(19) Europäisches Patentamt
European Patent Office
Office européen des brevets

(11) Publication number: **0 436 745 B1**

(12) **EUROPEAN PATENT SPECIFICATION**

(45) Date of publication of patent specification: **15.06.94**

(51) Int. Cl.[5]: **C09J 167/00**, C09J 163/00, H01B 3/30

(21) Application number: **89312451.1**

(22) Date of filing: **30.11.89**

(54) **A high performance epoxy based coverlay and bond ply adhesive with heat activated cure mechanism.**

(43) Date of publication of application:
**17.07.91 Bulletin 91/29**

(45) Publication of the grant of the patent:
**15.06.94 Bulletin 94/24**

(84) Designated Contracting States:
**BE DE FR GB IT NL**

(56) References cited:
**EP-A- 0 022 636**
**EP-A- 0 200 678**

**PATENT ABSTRACTS OF JAPAN, vol. 10, no. 166 (C-353)[2222], 13th June 1986, page 121 C 353; & JP-A-61 019 677 (TOUYOU KOUHAN K.K.) 28-01-1986**

(73) Proprietor: **COURTAULDS PERFORMANCE FILMS**
**6615 West Boston Street**
**Chandler Arizona 85226-9498(US)**

(72) Inventor: **Gardeski,Thomas F.**
**1259 E.Louis Way**
**Tempe Arizona(US)**

(74) Representative: **Taylor, Phillip Kenneth et al**
**W.P. THOMPSON & CO.**
**Coopers Building**
**Church Street**
**Liverpool L1 3AB (GB)**



Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(3.10/3.09/3.3.3)

## Description

During the past quarter century, the growth of the electronic circuits industry at an unrivaled pace has resulted in the development of higher performance materials of construction. However, the development of higher performance materials of construction has not resulted in the development of corresponding high performance adhesive materials and systems to bond the materials of construction together, especially in severe environmental conditions found in under-the-hood automotive and military applications. Adhesive materials and systems that are currently available meet some of the requirements for such properties as peel strength, chemical resistance, moisture resistance, high temperature stability, dimensional stability especially in the Z-axis direction adequate flow, room temperature storage stability prior to processing and ease of processing, but typically fail to meet one or more of the requirements for one or more of the properties.

A need has therefore been felt for an adhesive material that meets all the requisite property requirements for severe environmental conditions while retaining the ease of application.

It is an object of the present invention to provide an improved adhesive material.

It is a feature of the present invention to provide an improved material for use in bonding electronic circuit construction materials.

It is another feature of the present invention to provide an adhesive material using a two stage reaction sequence.

It is yet another feature of the present invention to provide an adhesive material using a two stage reaction sequence wherein the intermediate adhesive material resulting from the first reaction stage can be stored for long periods of time without deterioration of the properties of the adhesive material.

It is a still further feature of the present invention to provide an improved adhesive material by providing a first reaction between an aziridine component and a polyester component and by providing a second reaction between the aziridine/polyester component and at least one epoxy component, the at least one epoxy component being an electronic grade resin.

The foregoing and other features are accomplished, according to the present invention, by reacting a carboxyl-substituted high molecular weight hydroxyl terminated polyester component having a carboxylic acid functionality as determined by an acid number of 0.2 to 4 with a polymeric aziridine cure component, the reaction proceeding at room temperature to produce a polyester/aziridine component containing -NH- groups which react with at least one and preferably two epoxy components, one of the epoxy components being an electronic grade resin such as tris methane novolac epoxy resin. The second reaction requires a temperature of 121 °C - 204.4 °C (250 °F to 400 °F). The high reaction temperature permits the unreacted intermediate mixture of the polyester\aziridine component and the epoxy component(s) to have a long shelf life during which the implementation of the second reaction phase will result in high performance bonding. The intermediate mixture can be stored on a substrate protected by a release substrate or can be stored between two release substrates until needed.

These and other features of the present invention will be understood from the following description.

The composition of materials of the present invention comprises at least one and preferably two epoxy components, one epoxy component of which must be selected from a family of electronic grade resins such as tris methane epoxy novolac sold by Dow under the designation Quatrex 5010. The optional components are epoxies such as the flexible "bis-epi" and hard "novolac" types such as Celanese Epi-Rez 5132 and Dow D.E.N. 438, respectively. The composition of materials includes a high molecular weight hydroxyl terminated polyester component with minimal carboxcylic acid functionality, such as DuPont's 49002 and an aziridine curative component such as Xama 2 or 7 supplied by Cordova Chemical Co.

The two stage cure (reaction) sequence consists of first reacting the aziridine with the carboxcylic acid groups on the polyester as follows:

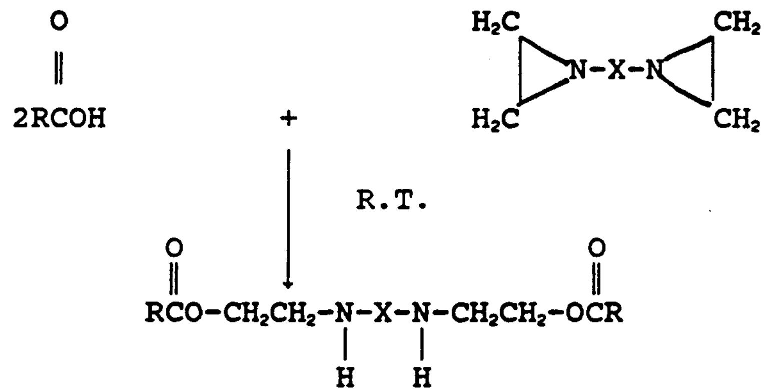


where R designates the high molecular weight polyester components and X designates the repeating unit of the aziridine component. This reaction takes place at room temperature.

The second reaction, which is unique to the present invention, is comprised of reacting the

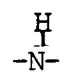

groups with

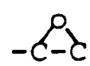

groups of the epoxy components as follows:

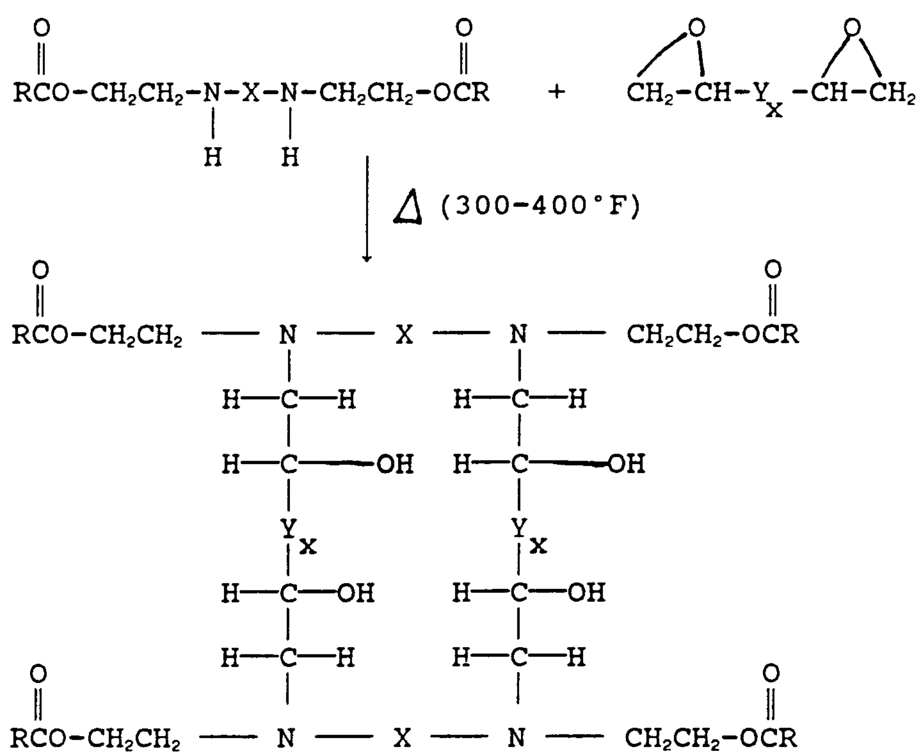


where Y designates the tris methane epoxy either alone or in conjunction with a bis-epi and/or novolac epoxy having structures shown below:

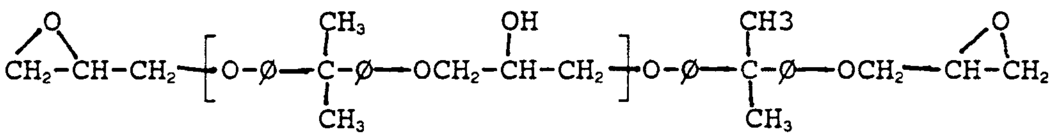

"BIS-EPI" EPOXY

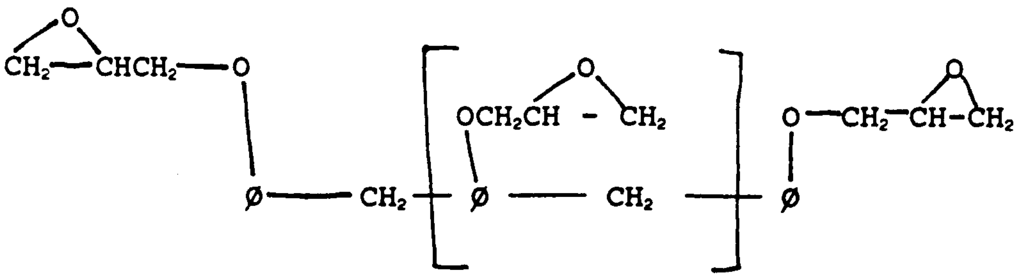

"NOVOLAC" EPOXY

Example of the Process

A mixture is prepared with the following components: a polyester resin component having a solids content of 17-20%, composed of DuPont 49002 base resin in a solvent mixture of 90% methylene chloride and 10% cyclohexanone by weight; an epoxy novolac is dissolved in methylethyl ketone, with an 85% solids content by weight, known commercially as Dow DEN 438 an electronic grade epoxy resin at 75% solids in methylethyl ketone known commercially as Dow Quatrex 5010; and a polyfunctional aziridine known commercially as Xama 7. The components mixture is prepared by combining 80% by solids content (by weight) of the polyester component to 10% by solids content (by weight) of the epoxy novolac to 10% by solids content (by weight) of the electronic grade epoxy and 0.25 parts (by weight) of the aziridine to 100 parts by weight of the above mixture including solvents. The component mixture can be prepared in two ways:

Procedure 1 The polyester and aziridine are combined, thoroughly mixed, then allowed to stand at room temperature for a minimum of 30 minutes prior to the epoxy additions to allow onset of the aziridine/carboxcylic acid reaction; or

Procedure 2) Thepolyester, epoxies, and aziridine are added separately without any mixing until all the components are in the vessel then thoroughly blended and allowed to stand for a minimum of 30 minutes prior to use to allow for onset of the aziridine/carboxcylic acid reaction.

The homogeneous solution is then applied by reverse roll coating technique to a 50.8 micrometers (2 mil) polyimide (e.g., Kapton) film to yield a 25.4 micrometer (1 mil) dry coating on the polyimide film. The polyimide film is dried in a 75 foot over at 7.62 metres per minute (25 feet per minute) and 100 ° C (212 ° F), combined to a 25.4 micrometers (1 mil) release substrate at the coater/laminator combining station, rolled up and stored at room temperature for future use. (According to another application, the homogeneous solution is stored between two release substrates, the adhesive material thereby being available for use with any surfaces to be bonded).

Sections are cut from the roll, the release substrate is removed, then the coated film was placed over a sheet of 1 oz. copper. The composite structure is then placed between two caul plates with a high temperature release material on both sides and pressed in a hydraulic press for 1 hour at 190.56 ° C (375 ° F) and 1.72 x $10^5$ A (250 psi) pressure. The resulting composite laminate structure exhibits the properties exhibited in Table I when tested in accordance with the ANSIIPC-FC-232B and 241B procedures.

| | |
|---|---|
| Initial Peel | 20 PLI |
| Peel After Solder | 21 PLI |
| Chemical Resistance | |
| MEK | 21 PLI |
| TOL | 20 PLI |
| IPA | 21 PLI |
| T111/MC | 21 PLI |
| Solder Float | Pass |
| Aging (96 hrs @ 135°C (275°F) in air circulating oven) | No Bond Strength Change |

where;

PLI = Pounds per lineal inch
MEK = Methylethyl ketone
TOL = Toluene
IPA = Isopropylalcohol
T111 = Trichloroethylene
MC = Methylene Chloride

TABLE I

OTHER EXAMPLES

1. The adhesive mixture is coated on polyimide (and laminate) film to foil in line at 148.9 ° C (300 ° F) and 6.21 x $10^5$ to 6.985 x $10^5$ Pa (90-100 psi) pressure. The resulting structure is post cured for 2 hours at 65.56 ° C (150 ° F), 2 hours @ 135 ° C (275 ° F) and 2 jpirs at 35- ° F.
2. Coat release substrate and combine to another release substrate to yield an unsupported film.

The adhesive composition of the present invention provides a coverlay and bond ply adhesive coating material consisting of 50-90% by weight polyester and 10-50% by weight epoxy with unique latent heat reactive cure mechanism comprised of one and preferably two epoxy components, one of which must be selected from a family of electronic grade resins such as tris methane epoxy novolac and the other epoxy or epoxies from the novolac or bis-epi epoxy families and the reaction product of a polymeric aziridine curative component with a high molecular weight carboxyl, a substituted hydroxyl terminated polyester with a carboxylic acid functionality as determined by an acid number ranging from 0.2 to 4.0. The adhesive material is cured in a two stage reaction sequence to provide a fully crosslinked network without the evolution of volatile by-products to provide an advanced laminating, coverlay, and bond ply adhesive for film to film, foil to film, foil to foil and hardboard to hardboard applications. The adhesive material has with excellent flexibility, superior bond strength, solder resistance, moisture and chemical resistance and superior Z-axis stability along with continuous and/or deferred processing capability. The high temperature of the second stage curing process provides that the coating material can be stored for long periods of time prior to the implementation of the curing process. The epoxy based adhesive materials can be coated on an insulating film or release substrate by a continuous process and stored at room temperature indefinitely prior to further processing, or laminated in-line to various foils or films, and which can be cured without the evolution of volatile by-products to provide a flexible bond-ply with superior overall properties to any currently available system with the added advantage of excellent Z-axis stability.

The foregoing description is included to illustrate the operation of the preferred embodiment. From the foregoing description, many variations will be apparent to those skilled in the art that would yet be encompassed by the spirit and scope of the invention.

## Claims

**1.** An adhesive composition characterised by comprising;

(i) from 50 to 90% by weight of the reaction product produced by reacting the carboxyl groups of a high molecular weight hydroxy terminated polyester with a carboxylic acid functionality as determined by an acid number of 0.2 to 4 with a polymeric aziridine to form a component-having

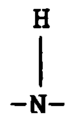

groups in the molecule and

(ii) from 10% to 50% by weight of at least one and preferably two epoxy components, one of epoxy component being selected from the family of electronic grade resins.

**2.** An adhesive composition as claimed in claim 1, characterised in that the electronic grade resin epoxy component is a tris methane novolac epoxy component.

**3.** An adhesive composition as claimed in claim 1 or 2, characterised in that component (ii) comprises at least one epoxy resin selected from bis-epi epoxy resins and novolac epoxy resins.

**4.** A composite structure comprising a layer of adhesive composition sandwiched between a solid substrate and a release substrate or between two release substrates characterised in that said adhesive composition is a composition as claimed in any of claims 1 to 3.

**5.** A method of bonding a surface of one substrate to a surface of a second substrate by applying an adhesive composition between said surfaces to be bonded and curing the adhesive composition characterised in that the adhesive composition is a composition as claimed in any of claims 1 to 3 and the curing is effected by heating the composition to a temperature at which the -NH- groups of component (i) react with the epoxy groups of component (ii).

**6.** A method as claimed in claim 5, characterised in that the composition is heated to a temperature of from 121 °C to 204.4 °C (250 °F to 400 °F).

**7.** A method as claimed in claim 5 or 6, characterised in that the carboxyl-containing polyester, the polymeric aziridine and the epoxy resin component are mixed together prior to reaction of the carboxyl-containing polyester with the polymeric aziridine.

## Patentansprüche

**1.** Klebstoffzusammensetzung, dadurch gekennzeichnet, daß sie folgendes umfaßt:

(i) 50 bis 90 Gew.-% des durch Umsetzen der Carboxylgruppen eines mit Hydroxy mit hohem Molekulargewicht terminiertem Polyesters mit einer Karbonsäurefunktionalität erzeugten Reaktionsproduktes, die bestimmt ist durch eine Säurezahl zwischen 0,2 und 4 mit einem polymeren Aziridin, zur Bildung eines Bestandteils mit -NH-Gruppen im Molekül, und

(ii) 10 bis 50 Gew.-% von wenigstens einem und vorzugsweise zwei Epoxyharzbestandteilen, wobei einer der Epoxyharzbestandteile ausgewählt ist aus der Familie der elektronisch verwendbaren Harzsorten.

**2.** Klebstoffzusammensetzung nach Anspruch 1, dadurch gekennzeichnet, daß der Epoxyharzbestandteil aus der Familie der elektronisch verwendbaren Harze ein Tris-Methan-Novolac-Epoxyharzbestandteil ist.

3. Klebstoffzusammensetzung nach Anspruch 1 oder 2, dadurch gekennzeichnet, daß der Bestandteil (ii) wenigstens einen Epoxyharz ausgewählt aus Bis-Epi-Epoxyharzen und Novolac-Epoxyharzen aufweist.

4. Compositstruktur, umfassend eine Schicht aus einer Klebstoffzusammensetzung in Verbundanordnung zwischen einem festen Substrat und einem lösenden Substrat oder zwischen zwei lösenden Substraten, dadurch gekennzeichnet, daß die genannte Klebstoffzusammensetzung eine Zusammensetzung nach den Ansprüchen 1 bis 3 ist.

5. Verfahren zum Verleimen einer Oberfläche eines Substrats mit einer Oberfläche eines zweiten Substrats durch Auftragen einer Klebstoffzusammensetzung zwischen den genannten zu verleimenden Oberflächen und Härten der Klebstoffzusammensetzung, dadurch gekennzeichnet, daß die Klebstoffzusammensetzung eine Zusammensetzung nach einem der Ansprüche 1 bis 3 ist und das Härten durch Erzitzen der Zusammensetzung auf eine Temperatur erfolgt, bei der die -NH-Gruppen des Bestandteils (i) mit den Epoxyharzgruppen des Bestandteils (ii) reagieren.

6. Verfahren nach Anspruch 5, dadurch gekennzeichnet, daß die Zusammensetzung auf eine Temperatur von 121 °C bis 204,4 °C (250 °F bis 400 °F) erhitzt wird.

7. Verfahren nach einem der Ansprüche 5 oder 6, dadurch gekennzeichnet, daß das polymere Aziridin und der Epoxyharzbestandteil vor der Reaktion des carboxylenthaltenden Polymers mit dem polymeren Aziridin vermischt werden.

**Revendications**

1. Composition adhésive caractérisée en ce qu'elle comporte;
   (i) de 50 à 90% en poids du produit de réaction provenant de la réaction des groupes carboxyles d'un polyester à terminaison hydroxylique de poids moléculaire élevé ayant une fonction acide carboxylique déterminée par un indice d'acide de 0,2 à 4 avec une aziridine polymère afin de former un composant ayant des groupes

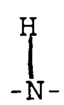

   dans la molécule et
   (ii) de 10 à 50% en poids d'au moins un et de préférence de deux composants époxydes, un des composants époxydes étant sélectionné dans la famille des résines de qualité électronique.

2. Composition adhésive selon la revendication 1, caractérisée en ce que le composant époxyde résine de qualité électronique est un composant époxyde tris méthane novolac.

3. Composition adhésive selon la revendication 1 ou 2, caractérisée en ce que le composant (ii) comporte au moins une résine époxyde sélectionnée de résines époxydes bis-épi et de résines époxydes novolac.

4. Structure composée comportant une couche de composition adhésive prise en sandwich entre un substrat solide et un substrat de libération ou entre deux substrats de libération caractérisée en ce que dans ladite composition adhésive est une composition selon une quelconque des revendications 1 à 3.

5. Procédé de liaison d'une surface d'un substrat sur une surface d'un second substrat par l'application d'une composition adhésive entre lesdites surfaces à lier et la polymérisation de la composition adhésive caractérisé en ce que la composition adhésive est une composition selon l'une quelconque des revendications 1 à 3 et la polymérisation est exécutée par chauffage de la composition à une température à laquelle les groupes -NH-du composant (i) réagissent avec les groupes époxydes du composant (ii).

6. Procédé selon la revendication 5, caractérisé en ce que la composition est chauffée à une température allant de 121°C à 204,4°C (250°F à 400°F).

7. Procédé selon la revendication 5 ou 6 caractérisé en ce que le polyester contenant du carboxyle, l'aziridine polymère et le composant résine époxyde sont mélangés ensemble avant la réaction du polyester contenant du carboxyle avec l'aziridine polymère.